# EUROPEAN PATENT SPECIFICATION

(11) **EP 1 438 735 B1**
(45) Date of publication and mention of the grant of the patent: **01.03.2006**
(21) Application number: 02782242.8
(22) Date of filing: 25.10.2002
(51) Int. Cl.: H01J 37/32

(54) **METHODS AND APPARATUS FOR PLASMA DOPING BY ANODE PULSING**
VERFAHREN UND GERÄT ZUR PLASMADOTIERUNG DURCH PULSIEREN DER ANODE
PROCEDES ET APPAREIL DE DOPAGE AU PLASMA PAR APPLICATION D'IMPULSIONS SUR UNE ANODE

(30) Priority: 26.10.2001 US 5613
(43) Date of publication of application: 21.07.2004
(73) Proprietor: Varian Semiconductor Equipment Associates, Inc., Gloucester MA 01930 (US)
(72) Inventor: WALTHER, Steven, R., Andover, MA 01810 (US); PEDERSEN, Bjorn, O., Chelmsford, MA 01824 (US)
(74) Representative: Ribeiro, James Michael
(86) International application number: PCT/US2002/034346
(87) International publication number: WO 2003/036681

(56) References cited:
- WO-A-99/06110
- US-A- 5 911 832

## Description

### Field of the Invention

This invention relates to plasma doping of semiconductor wafers and, more particularly, to methods and apparatus for plasma doping by anode pulsing, thereby permitting the semiconductor wafer to be grounded.

### Background of the Invention

Ion implantation has become a standard technique for introducing conductivity-altering impurities into semiconductor wafers. A desired impurity material is ionized in an ion source, the ions are accelerated to form an ion beam of prescribed energy, and the ion beam is directed at the surface of the wafer. The energetic ions in the beam penetrate into the bulk of the semiconductor material and are embedded into the crystalline lattice of the semiconductor material to form a region of desired conductivity.

Ion implantation systems usually include an ion source for converting a gas or a solid material into a well-defined ion beam. The ion beam is mass analyzed to eliminate undesired species, is accelerated to a desired energy and is directed onto a target plane. The beam may be distributed over the target area by beam scanning, by target movement or by a combination of beam scanning and target movement. Examples of prior art ion implanters are disclosed in U.S. Patent No. 4,276,477 issued June 30, 1981 to Enge; U.S. Patent No. 4,283,631 issued August 11, 1981 to Turner; U.S. Patent No. 4,899,059 issued February 6, 1990 to Freytsis et al.; U.S. Patent No. 4,922,106 issued May 1, 1990 to Berrian et al.; and U.S. Patent No. 5,350,926 issued September 27, 1994 to White et al.

A well-known trend in the semiconductor industry is toward smaller, higher speed devices. In particular, both the lateral dimensions and the depths of features in semiconductor devices are decreasing. State of the art semiconductor devices require junction depths less than 1,000 Angstroms and may eventually require junction depths on the order of 200 Angstroms or less.

The implanted depth of the dopant material is determined, at least in part, by the energy of the ions implanted into the semiconductor wafer. Shallow junctions are obtained with low implant energies. However, ion implanters are typically designed for efficient operation at relatively high implant energies, for example in the range of 20 keV to 400 keV, and may not function efficiently at the energies required for a shallow junction implantation. At low implant energies, such as energies of 2 keV and lower, the current delivered to the wafer is much lower than desired and in some cases may be near zero. As a result, extremely long implant times are required to achieve a specified dose, and throughput is adversely affected. Such reduction in throughput increases fabrication cost and is unacceptable to semiconductor device manufacturers.

Plasma doping systems have been studied for forming shallow junctions in semiconductor wafers. In one type of plasma doping system, a semiconductor wafer is placed on a conductive platen, which functions as a cathode, located in a plasma doping chamber. An ionizable gas containing the desired dopant material is introduced into the chamber, and a voltage pulse is applied between the platen and an anode, causing formation of a glow discharge plasma having a plasma sheath in the vicinity of the wafer. The applied voltage pulse causes ions in the plasma to cross the plasma sheath and to be implanted into the wafer. The depth of implantation is related to the voltage applied between the wafer and the anode. Very low implant energies can be achieved. Plasma doping systems are described, for example, in U.S. Patent No. 5,354,381 issued October 11, 1994 to Sheng; U.S. Patent No. 6,020,592 issued February 1, 2000 to Liebert et al.; and U.S. Patent No. 6,182,604 issued February 6, 2001 to Goeckner et al.

In other types of plasma systems, known as plasma immersion systems, a continuous RF voltage is applied between the platen and the anode, thus producing a continuous plasma. At intervals, a high voltage pulse is applied between the platen and the anode, causing positive ions in the plasma to be accelerated toward the wafer.

Prior art plasma doping systems typically utilize a configuration wherein the anode and the chamber walls are grounded and the cathode is pulsed negative. This configuration has the advantage that only the wafer is implanted with ions from the plasma. A plasma immersion system which utilizes a pulsed anode is disclosed in U.S. Patent No. 5,911,832 issued June 15, 1999 to Denholm et al. A disadvantage of the disclosed approach is that shielding of the chamber walls is required to limit power consumption and to limit sputtering of the chamber walls and the resulting wafer contamination. It is difficult to effectively shield vacuum pumping ports and vacuum pumping equipment connected to the chamber. Accordingly, there is a need for improved plasma doping systems and methods.

### Summary of the Invention

According to a first aspect of the invention as claimed in claim 1 plasma doping apparatus is provided. The plasma doping apparatus comprises a housing defining a plasma doping chamber, a platen for supporting a workpiece in the plasma doping chamber, the platen being coupled to a reference potential such as ground, an anode spaced from the platen in the plasma doping chamber, a process gas source coupled to the plasma doping chamber, a vacuum vessel enclosing the plasma doping chamber and defining an outer chamber, a primary vacuum pump connected to the vacuum vessel, a pulse source for applying pulses to the anode, and a controller. The controller establishes a controlled plasma doping environment in the plasma doping chamber in a processing mode, typically a plasma doping mode, and establishes a gas connection between the plasma doping chamber and the outer chamber in a non-processing mode, typically a vacuum pumping and wafer exchange mode. A plasma containing ions of the process gas is produced in the plasma doping chamber between the anode and the platen. The plasma has a plasma sheath in the vicinity of the workpiece. The pulses applied to the anode accelerate the ions across the plasma sheath toward the platen for implantation into the workpiece.

In one embodiment, the plasma is produced by the pulses applied to the anode. In some embodiments, the plasma is pulsed. In other embodiments, the plasma is continuous.

In some embodiments, the plasma doping apparatus further comprises a secondary vacuum pump connected to the plasma doping chamber for pumping the plasma doping chamber in the processing mode. The primary vacuum pump may be used for vacuum pumping of the plasma doping chamber in the non-processing mode, and the secondary vacuum pump may be used to maintain a desired pressure of the process gas in the processing mode. As a result, the secondary vacuum pump can have a relatively small capacity and can be connected to the plasma doping chamber through a throttle pumping port.

In other embodiments, the plasma doping apparatus further comprises a controlled conductance aperture between the plasma doping chamber and the outer chamber. The plasma doping chamber is pumped through the controlled conductance aperture in the processing mode.

The platen may be movable between a processing position sealed into the plasma doping chamber and a retracted position removed from the plasma doping chamber. The control device may comprise means for moving the platen between the processing position in the processing mode and the retracted position in the non-processing mode.

The plasma doping apparatus may further comprise a hollow electrode surrounding a space between the platen and the anode. In one embodiment, the hollow electrode is electrically connected to the anode. In another embodiment, the apparatus further comprises a hollow electrode pulse source electrically connected to the hollow electrode. In this embodiment, the plasma is produced by the pulses applied to the anode and the pulses applied to the hollow electrode.

According to another aspect of the invention as claimed in claim 6 a plasma doping method is provided. The plasma doping method comprises the steps of providing a plasma doping chamber containing a platen coupled to a reference potential and an anode spaced from the platen, supporting the workpiece on the platen, supplying a process gas to the plasma doping chamber, enclosing the plasma doping chamber within a vacuum vessel that defines an outer chamber, vacuum pumping the vacuum vessel with a primary vacuum pump, applying pulses to the anode, and controlling the apparatus to establish a controlled plasma doping environment in the plasma doping chamber in a processing mode and to establish a gas connection between the plasma doping chamber and the outer chamber in a non-processing mode. A plasma containing ions of the process gas is produced in the plasma doping chamber between the anode and the platen. The plasma has a plasma sheath in the vicinity of the workpiece. The pulses applied to the anode accelerate the ions across the plasma sheath toward the platen for implantation into the workpiece.

### Brief Description of the drawings

For a better understanding of the present invention, reference is made to the accompanying drawings, which are incorporated herein by reference and in which:
FIG. 1A is a top schematic view of a beamline ion implanter suitable for implementation of the present invention;
FIG. 1B is a top schematic view of the beamline ion implanter of FIG. 1A, showing beamline components;
FIG. 2 is a schematic cross-sectional side view of a process system in accordance with an embodiment of the invention, shown in the beamline ion implant mode;
FIG. 3 is a schematic cross-sectional side view of the process system of FIG. 2, shown in the plasma doping mode;
FIG. 4 is a schematic block diagram of the process system of FIGS. 2 and 3;
FIG. 5 is a schematic block diagram of a first embodiment of the plasma doping module, shown with the platen sealed into the plasma doping chamber;
FIG. 6 is a schematic block diagram of the first embodiment of the plasma doping module, shown with the platen removed from the plasma doping chamber; and
FIG. 7 is a schematic block diagram of a second embodiment of the plasma doping module, not falling within the scope of the claims, shown with the platen sealed into the plasma doping chamber.

### Detailed Description

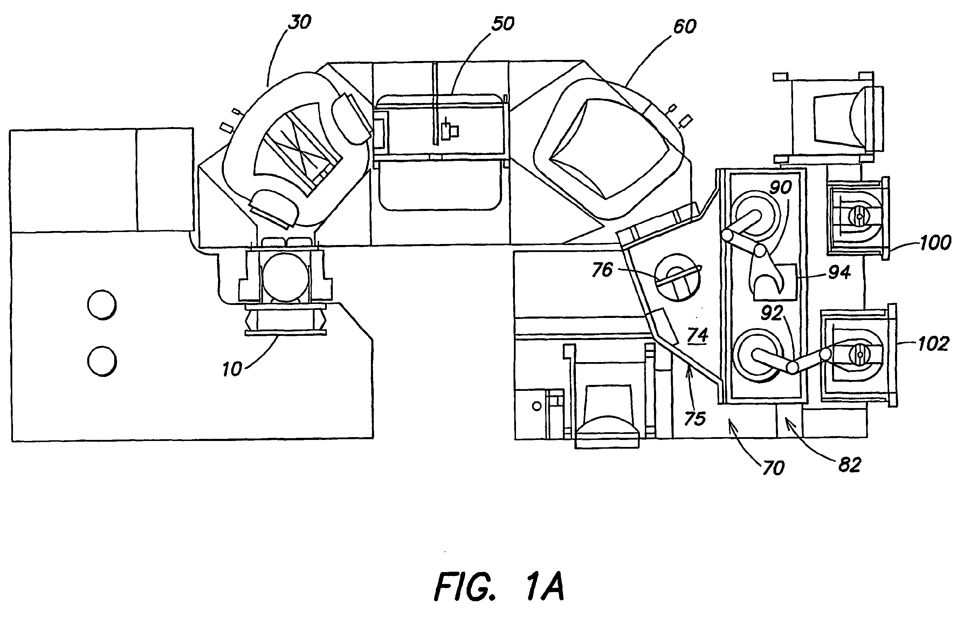

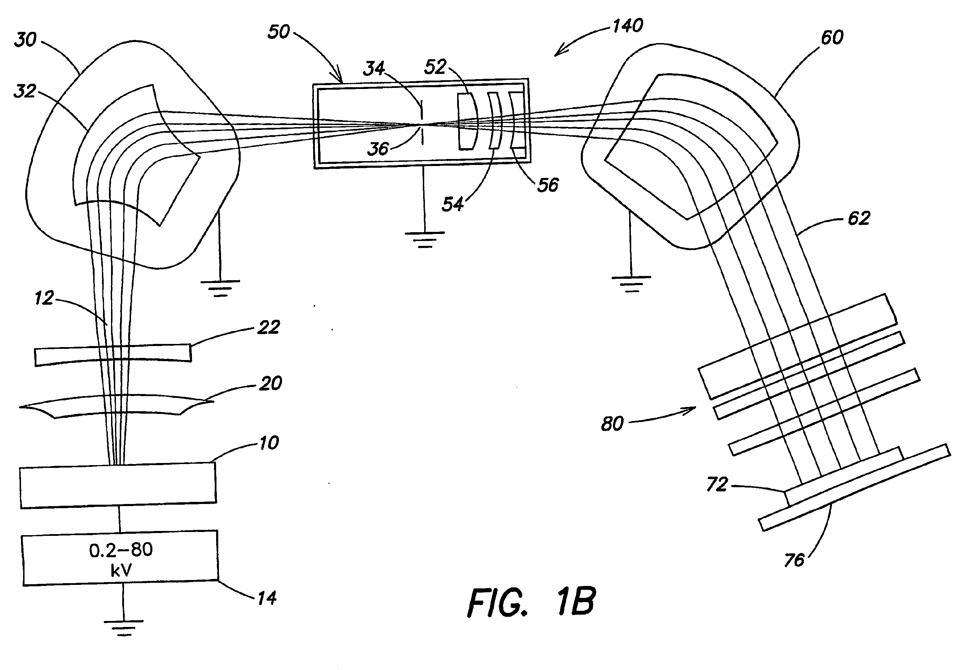

A block diagram of an embodiment of a beamline ion implanter suitable for implementation of the invention is shown in FIGS. 1A and 1B. An ion source 10 generates ions and supplies an ion beam 12. As known in the art, ion source 10 may include an ion chamber and a gas box containing a gas to be ionized. The gas is supplied to the ion chamber where it is ionized. The ions thus formed are extracted from the ion chamber to form ion beam 12. Ion beam 12 has an elongated cross-section and is ribbon-shaped, with a long dimension of the beam cross-section preferably having a horizontal orientation. A power supply 14 is connected to an extraction electrode of ion source 10 and provides a voltage that may be adjustable, for example, from about 0.2 to 80 keV. Thus, ions from ion source 10 are accelerated to energies of about 0.2 to 80 keV by the voltage from power supply 14. The construction and operation of ion sources are well-known to those skilled in the art.

Ion beam 12 passes through a suppression electrode 20 and a ground electrode 22 to a mass analyzer 30. The mass analyzer 30 includes a resolving magnet 32 and a masking electrode 34 having a resolving aperture 36. Analyzing magnet 32 deflects ions in ion beam 12 such that ions of a desired ion species pass through resolving aperture 36, and undesired ion species do not pass through resolving aperture 36 but are blocked by the masking electrode 34. In a preferred embodiment, resolving magnet 32 deflects ions of a desired species by 90°.

Ions of the desired species pass through resolving aperture 36 to a first deceleration stage 50 positioned downstream of mass analyzer 30. Deceleration stage 50 may include an upstream electrode 52, a suppression electrode 54 and a downstream electrode 56. Ions in the ion beam are decelerated by deceleration stage 50 and then pass through an angle corrector magnet 60. Angle corrector magnet 60 deflects the ions and converts the ion beam from a diverging ion beam to a ribbon beam 62 having substantially parallel ion trajectories. In a preferred embodiment, angle corrector magnet 60 deflects ions of the desired species by 70°. The ion implanter may include a second deceleration stage 80 positioned downstream of angle corrector magnet 60.

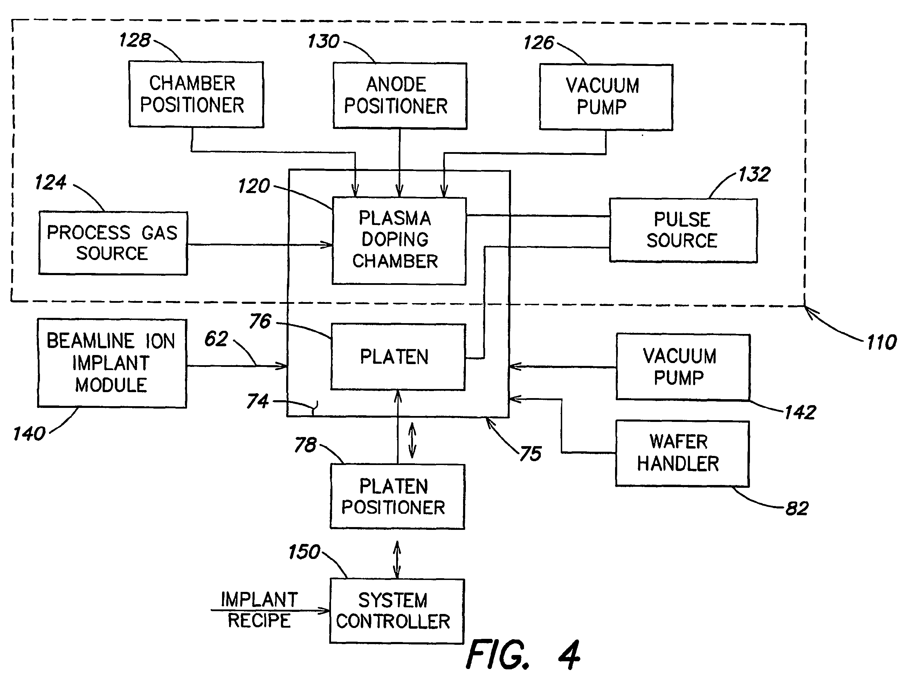

An end station 70, or process station, supports one or more semiconductor wafers, such as wafer 72, in a process chamber 74 such that ions of the desired species are implanted into the semiconductor wafer. Process chamber 74 is enclosed by a vacuum vessel 75. The end station 70 may include a cooled electrostatic platen 76 and a platen positioner 78 (FIG. 4) for mechanically scanning wafer 72 perpendicular to the long dimension of the ribbon ion beam 62, so as to distribute the ions over the surface of wafer 72.

End station 70, as shown in FIG. 1A, may include an automated wafer handler 82 for introducing wafers into the ion implanter and for removing wafers after implantation. Wafer handler 82 shown in FIG. 1A includes wafer robots 90 and 92, a wafer orienter 94 and load locks 100 and 102. One of the wafer robots removes a wafer from a cassette or other wafer carrier in one of the load locks and transfers the wafer to platen 76. The wafer may be oriented at wafer orienter 94. Following processing, the wafer is removed from platen 76 and is returned to its cassette or other wafer carrier by one of the wafer robots.

End station 70 may also include a dose measuring system, a plasma flood gun or an electron flood gun, and other known components. It will be understood that the entire path traversed by the ion beam is evacuated during ion implantation.

In accordance with an aspect of the invention, a plasma doping module is combined with a beamline ion implant module to form an integrated processing system. The integrated processing system may be used to process wafers by beamline ion implantation, by plasma doping, or both, depending on the required implant recipe for the wafers. Wafers in a single process chamber may have access to a beamline ion implant module and to a plasma doping module. The integrated processing system may include any beamline ion implant module and any plasma doping module. A variety of different beamline ion implanter architectures are known to those skilled in the art. Various plasma doping architectures are described below.

The beamline ion implant module may include all or part of a beamline ion implanter. In one embodiment, described below, a plasma doping module is incorporated into the end station of a beamline ion implanter. In another embodiment, the end station of a beamline ion implanter is replaced with a process chamber. The process chamber is connected to a beamline ion implant module and contains or is connected to a plasma doping module.

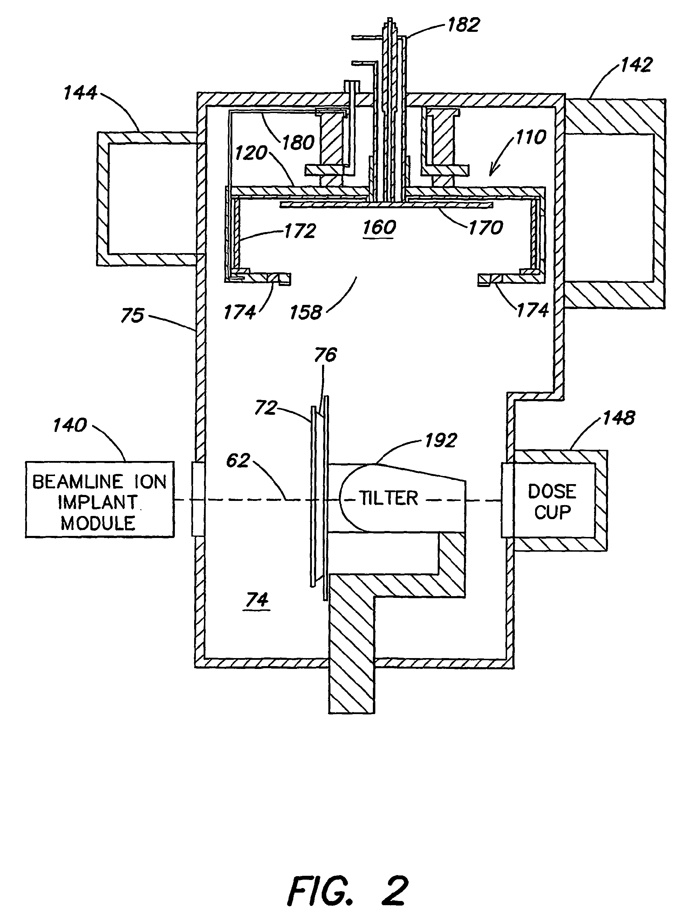

In an embodiment shown in FIGS. 2-4, a plasma doping module 110 is incorporated into process chamber 74, with one or more components of plasma doping module 110 located within vacuum vessel 75 and one or more components of plasma doping module 110 located outside vacuum vessel 75, as shown in FIG. 4. Plasma doping module 110 may include a plasma doping chamber 120, a process gas source 124, a vacuum pump 126, a chamber positioner 128, an anode positioner 130 connected to an anode located in plasma processing chamber 120, and a pulse source 132 connected between platen 76 and the anode in plasma doping chamber 120. Process gas source 124 and vacuum pump 126 are connected by gas conduits to plasma doping chamber 120, and chamber positioner 128 is mechanically connected to plasma doping chamber 120. Additional embodiments of plasma doping module 110 are described below.

A beamline ion implant module 140 supplies ribbon ion beam 62 to process chamber 74. Referring to FIGS. 1A and 1B, the components of beamline ion implant module 140 may include ion source 10, mass analyzer 30, deceleration stage 50, angle corrector magnet 60 and second deceleration stage 80. The beamline ion implant module 140 may employ any beamline ion implanter architecture.

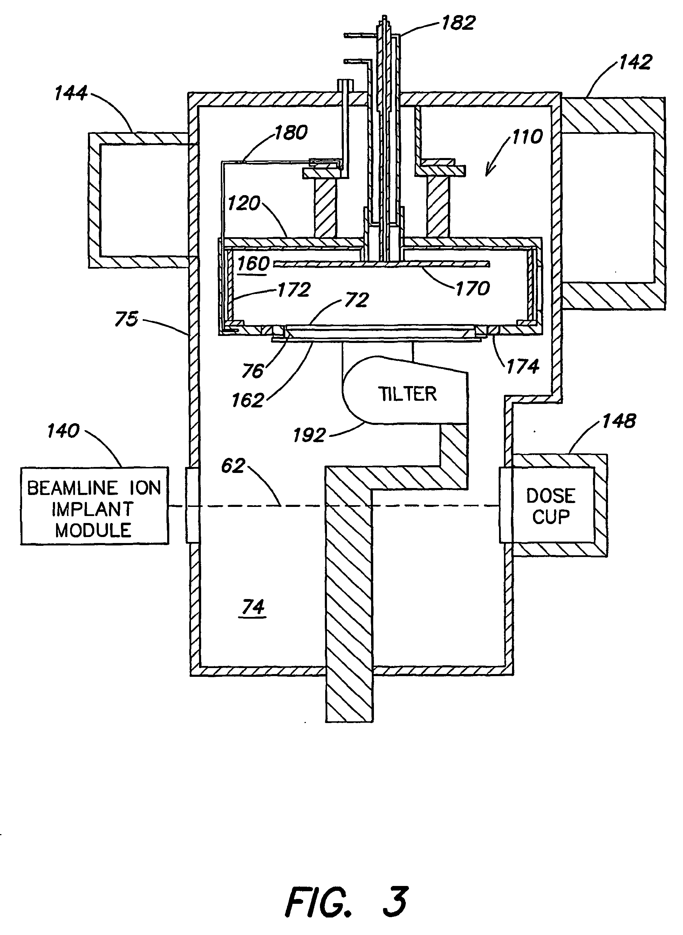

Additional components of the integrated processing system include vacuum vessel 75, platen 76, platen positioner 78 and wafer handler 82. In a preferred embodiment, platen 76 may be an electrostatic wafer clamp as described for example in U.S. Patent No. 5,452,177 issued September 19, 1995 to Frutiger. A vacuum pump 142 controls the pressure within process chamber 74. In the embodiment of FIGS. 2 and 3, vacuum pump 142 comprises a cryogenic pump. Additional vacuum pumps, such as a turbomolecular pump 144, may be used for increased vacuum pumping capability. A Faraday cup 148 may be positioned in alignment with ribbon ion beam 62 for dose and uniformity measurements. A system controller 150 controls the elements of the integrated processing system. System controller may comprise a programmed general purpose computer, including for example a microprocessor, memory, interfaces to the components of the integrated processing system and peripheral devices, such as a keyboard and a video display terminal.

Platen 76 holding wafer 72 may be positioned to intercept ribbon ion beam 62 in a beamline implant mode, as shown in FIG. 2, or may be positioned in plasma doping chamber 120 in a plasma doping mode, as shown in FIG. 3. The system thus constitutes an integrated processing system that is capable of beamline ion implantation and plasma doping. The system controller 150 controls the operating mode in response to inputs that define the parameter of each implant.

Referring to FIGS. 2 and 3, plasma doping chamber 120 defines an enclosed volume 160 in the plasma doping mode. In the plasma doping mode shown in FIG. 3, platen 76 is positioned in an opening 158 in plasma doping chamber 120, and a platen halo 162 seals platen 76 into plasma doping chamber 120. Platen 76 thus positions wafer 72 within plasma doping chamber 120. The platen 76 supports wafer 72 and provides an electrical connection to wafer 72. An anode 170 is positioned within plasma doping chamber 120 in spaced relation to platen 76, which functions as a cathode. Anode 170 may be movable by anode positioner 130 (FIG. 4) in a direction perpendicular to the surface of platen 76. The region between platen 76 and anode 170 may be surrounded by a hollow electrode 172 as described in U.S. Patent No. 6,182,604 issued February 6, 2001 to Goeckner et al. A shield ring 174 containing a Faraday beam sensor may surround platen 76 as described in U.S. Patent No. 6,020,592 issued February 1, 2000 to Liebert et al. The enclosed volume 160 within plasma doping chamber 120 may be connected by a coaxial gas line 180 to process gas source 124 (FIG. 4). In addition, enclosed volume 160 may be connected through a throttled pumping port 182 to vacuum pump 126 (FIG. 4). Plasma doping chamber 120 is preferably movable by chamber positioner 128 (FIG. 4) between a plasma doping position shown in FIG. 3 and a retracted position shown in FIG. 2. The plasma doping chamber 120 moves upwardly from the plasma doping position to the retracted position.

The platen positioner 78 (FIG. 4) positions platen 76 in accordance with the operating mode of the processing system. In the beamline implant mode shown in FIG. 2, platen 76 and wafer 72 are orientated vertically in the path of ribbon ion beam 62, and platen 76 is mechanically scanned upwardly and downwardly by platen positioner 78 to distribute ribbon ion beam 62 over the surface of wafer 72. Platen positioner 78 may include a tilter 190 for tilting wafer 72 at a desired angle with respect to ribbon ion beam 62. Preferably, platen 76 is moved below ribbon ion beam 62 during part of the mechanical scan to permit Faraday cup 148 to monitor ion beam current.

In the plasma doping mode, the platen 76 and wafer 72 may be oriented horizontally. Platen 76 and wafer 72 are moved upwardly into opening 158 in plasma process chamber 120, and platen halo 162 is sealed to plasma process chamber 120.
Thus, platen 76 and wafer 72 are sealed into plasma doping chamber 120 as shown in FIG. 3. During plasma doping, platen 76 and wafer 72 may remain stationary.

In a wafer exchange mode, platen 76 and wafer 72 are oriented horizontally and are lowered below the path of ribbon ion beam 62. Wafer 72 is removed from platen 72 by one of the wafer robots 90, 92 (FIG. 1A) and a new wafer is placed on platen 76 for processing. Wafer handling techniques are known to those skilled in the art and are not discussed further.

In operation, the system controller 150 may receive an implant recipe that specifies the parameters for doping a batch of wafers. The implant recipe may, for example, specify a dopant species, an energy and a dose to be applied to the wafers. The system controller 150 may select an operating mode based on the implant recipe. For example, implant energies greater than 2 keV may utilize the beamline implant mode and energies less than 2 keV may utilize the plasma doping mode.

When the beamline implant mode is selected by system controller 150, a wafer of the batch is loaded onto platen 76 by wafer handler 82 and platen 76 is rotated to the vertical position as shown in FIG. 2. The beamline ion implant module 140 is tuned to provide the desired implant parameters and to generate ribbon ion beam 62. The platen positioner 78 mechanically scans platen 76 and wafer 72 vertically through ribbon ion beam 62, typically multiple times, until a desired dose and dose uniformity are achieved. Dose and dose uniformity may be monitored by Faraday cup 148. During the beamline implant mode, the plasma doping chamber 120 remains in the retracted position shown in FIG. 2 in order to provide clearance for mechanical scanning, and the components of plasma doping module 122 are inactivated. Following completion of processing, the wafer 72 may be removed from the process chamber 74 by wafer handler 82.

When the plasma doping mode is selected by system controller 150, the beamline ion implant module 140 is inactivated, and plasma doping chamber 120 is lowered by chamber positioner 128 to the plasma doping position shown in FIG. 3. After a wafer is loaded onto platen 76 by wafer handler 82, the platen 76 and wafer 72 are raised into the opening 150 in plasma doping chamber 120 and are sealed into plasma doping chamber 120. The process gas source 124 and the vacuum pump 126 are activated to provide a process gas at the desired pressure within plasma doping chamber 120. The pulse source 132 is activated, causing formation of a plasma between platen 76 and anode 170 and acceleration of ions toward wafer 72. For very low energy implants, hollow electrode 172 may be utilized as described below. The applied dose may be monitored by the Faraday beam sensor in shield ring 174. When the desired dose is achieved, the pulse source 132 and the process gas source 124 are deactivated, and vacuum pump 126 pumps the plasma doping chamber 120 to a desired vacuum level. The platen 76 and wafer 72 are then lowered from plasma doping chamber 120, and wafer 72 may be removed by wafer handler 82. The vacuum pump 142 may pump residual gas that escapes into process chamber 74 when platen 76 is lowered from plasma doping chamber 120. If desired, wafer 72 may be processed by plasma doping and beamline ion implantation without removing wafer 72 from process chamber 74.

It will be understood that the plasma doping chamber 120 defines a process environment in enclosed volume 160 that may be very different from the process environment within process chamber 74. In particular, process chamber 74 is preferably maintained at high vacuum, for example 20 microtorr, during beamline ion implantation. The pressure within plasma doping chamber 120 during operation in the plasma doping mode may be in a range of about 0.13Pa (1 millitorr) to about 66.7Pa (500 militorr). A process gas, such as BF₃, N₂, Ar, PH₃, AsH₃ or B₂H₆, for example, may be used.

In the embodiment of FIGS. 2 and 3, plasma doping chamber 120 is located within process chamber 74 and is movable between a plasma doping position and a retracted position. In other embodiments, plasma doping chamber 120 may be fixed in position if the platen positioner 78 provides a sufficient range of platen travel to permit mechanical scanning and access to plasma doing chamber 120. In addition, plasma doping chamber 120 may be located partially or entirely outside process chamber 74, such that the plasma doping chamber 120 can be accessed from process chamber 74. For example, plasma processing chamber 120 may be accessed from process chamber 74 through a gate valve.

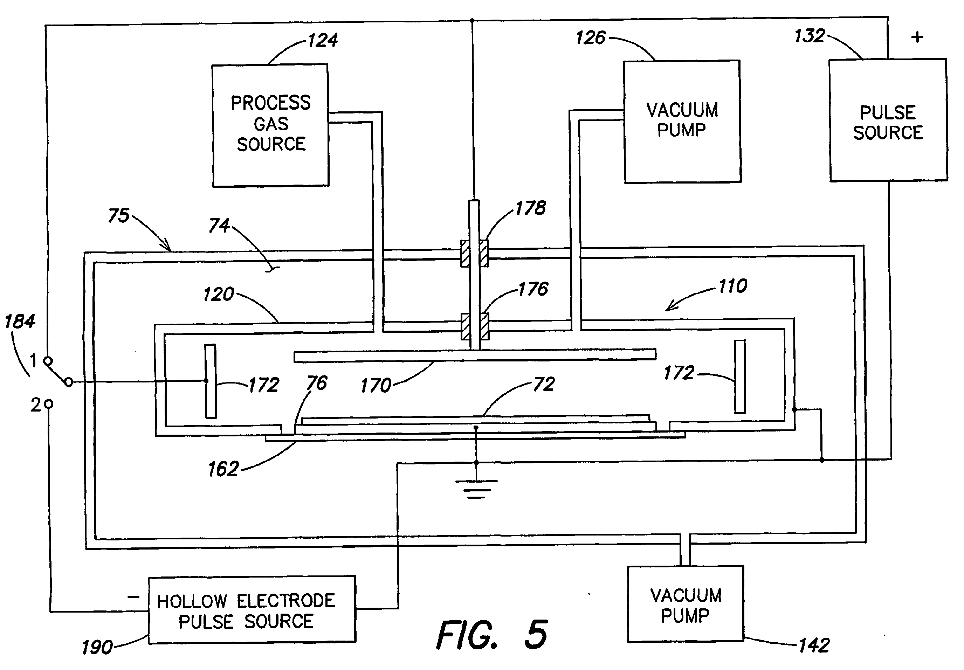

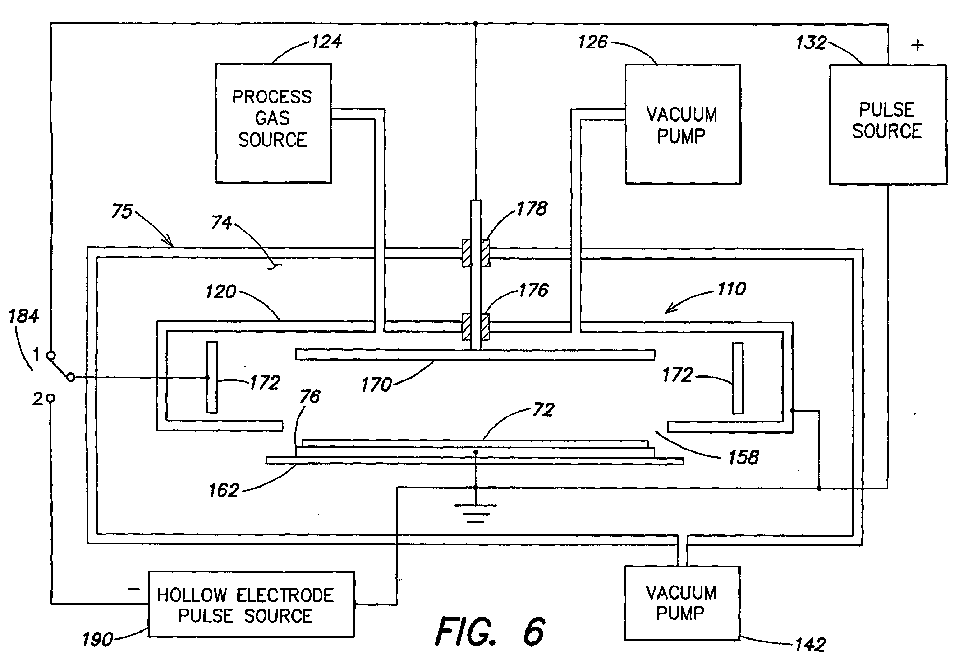

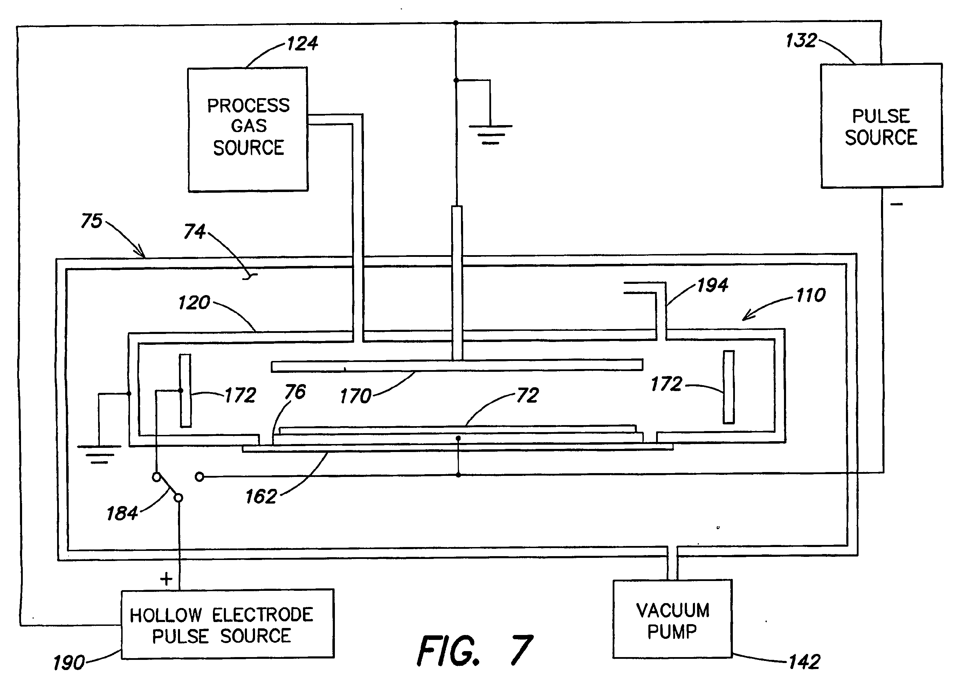

Schematic block diagrams of a first embodiment of plasma doping module 110 are shown in FIGS. 5 and 6. A schematic block diagram of a second embodiment of plasma doping module 110 is shown in FIG. 7. Like elements in FIGS. 1-7 have the same reference numerals. In FIGS. 5-7, vacuum vessel 75 and vacuum pump 142 are shown because these elements are involved in the operation of the plasma doping module. The other components of the integrated processing system are omitted in FIGS. 5-7.

In FIG. 5, platen 76 is sealed into plasma doping chamber 120 in the plasma doping mode. In the configuration of FIG. 5, plasma doping chamber 120 is isolated from process chamber 74, and different environments may be maintained in plasma doping chamber 120 and processing chamber 74. In FIG. 6, platen 76 is lowered from opening 158 in plasma doping chamber 120. Thus, plasma doping chamber 120 and process chamber 74 have a common environment. This configuration is applicable to the beamline implant mode and the wafer exchange mode.

As shown in FIGS. 5 and 6, plasma doping chamber 120 is located within vacuum vessel 75. Plasma doping chamber 120 is connected to vacuum pump 126, and vacuum vessel 75 is connected to vacuum pump 142. Vacuum pump 142 pumps both process chamber 74 and plasma doping chamber 120 when platen 76 is lowered from opening 158 in plasma doping chamber 120, as shown in FIG. 6. Thus, plasma doping chamber 120 has a relatively low pressure at the time when platen 76 is sealed into plasma doping chamber 120. After plasma doping chamber 120 is sealed, plasma doping chamber 120 is pumped by vacuum pump 126. This arrangement permits vacuum pump 126 to have a relatively small pumping capacity, while vacuum pump 142 has a larger pumping capacity sufficient to pump vacuum vessel 75. Thus, vacuum pump 142 may be considered as a primary vacuum pump and vacuum pump 126 may be considered as a secondary vacuum pump in the embodiment of FIGS. 5 and 6.

Vacuum pump 142 evacuates plasma doping chamber 120 to a desired pressure level with platen 76 in the lowered position shown in FIG. 6. Platen 76 is then sealed into plasma doping chamber 120 as shown in FIG. 5. Process gas source 124 introduces a process gas to plasma doping chamber 120, and vacuum pump 126 provides sufficient pumping to maintain a desired pressure of the process gas within plasma doping chamber 120. Because vacuum pump 126 is not required to pump plasma doping chamber 120 from atmospheric pressure to the process pressure, the port connecting plasma doping chamber 120 to vacuum pump 126 may be throttled, and vacuum pump 126 may have a relatively small capacity. After processing is complete, process gas source 124 is turned off and vacuum pump 126 pumps the remaining process gas from plasma doping chamber 120. Then, platen 76 is lowered, and vacuum pump 142 provides further vacuum pumping of plasma doping chamber 120.

As further shown in FIGS. 5 and 6, platen 76 and the walls of plasma doping chamber 120 may be connected to a reference potential, such as ground, and pulse source 132 may provide a series of pulses to anode 170. Anode 170 is electrically isolated from plasma doping chamber 120 by an insulator 176 and is electrically isolated from vacuum vessel 75 by an insulator 178. Hollow electrode 172 is connected by a switch 184 to pulse source 132 or to a hollow electrode pulse source 190, as described below.

In the typical case where positive ions are to be implanted into wafer 72, positive pulses are applied to anode 170. In the case where the voltage corresponding to the required implant energy is sufficient to initiate a plasma discharge between anode 170 and wafer 72, pulse source 132 may be used to initiate a plasma discharge and to accelerate ions from the plasma into wafer 72. The positive pulses accelerate positive ions across the plasma sheath and into wafer 72. In the case where negative ions are to be implanted into wafer 72, pulse source 132 applies a negative pulse to anode 170. Where pulse source 132 is used to initiate a plasma discharge between anode 170 and wafer 72, hollow electrode 172 is connected to pulse source 132 by placing switch 184 in position 1 shown in FIGS. 5 and 6. In this configuration, the plasma is substantially surrounded, except at wafer 72, by positively biased anode 170 and hollow electrode 172, and positively charged ions in the plasma are accelerated to wafer 72.

In the case where a very low implant energy is required and the corresponding amplitude of the pulses supplied by pulse source 132 is not sufficient to initiate a plasma discharge between anode 170 and wafer 72, switch 184 is placed in position 2, and hollow electrode 172 is connected to hollow electrode pulse source 190. In the embodiment of FIGS. 5 and 6, a negative pulse is applied to hollow electrode 172 when positive ions are to be implanted into wafer 72. The negative pulse applied to hollow electrode 172 combined with the positive pulse applied to anode 170 is sufficient to initiate a plasma discharge between anode 170 and wafer 72, and a relatively small amplitude pulse applied to anode 170 achieves very low implant energy. For example, where singly-charged positive ions having energies of 500 electron volts are to be implanted into wafer 72, switch 184 is placed in position 2, pulse source 132 is programmed to generate positive 500 volt pulses, and hollow electrode pulse source 190 is programmed to generate negative 1000 volt pulses. The pulse sources 132 and 190 are synchronized to generate pulses that overlap in time. This results in 1500 volt pulses being applied between anode 170 and hollow electrode 172, which is sufficient to initiate a plasma discharge. The positive ions in the plasma discharge are accelerated to 500 electron volts by the pulses applied between anode 170 and wafer 72.

The plasma doping module shown in FIGS. 5 and 6, wherein wafer 72 and plasma 76 are grounded, has several advantages. Because the wafer is grounded, biasing and dose measurement are simplified. The wafer 76 is substantially surrounded by anode 170 and hollow electrode 172, and plasma doping chamber 120 is connected through a throttled pumping port to vacuum pump 126. As a result, contamination of wafer 76 caused by sputtering of chamber walls and vacuum pumping components is limited. In addition, the surface area for collecting ions is limited, thereby reducing the load places on pulse sources 132 and 190. To further reduce contamination caused by sputtering, hollow electrode 172 and other exposed elements may be coated with a non-contaminating material, such as silicon in the case of a silicon wafer. The throttled pumping port reduces the tendency for ions in the plasma to enter the pumping port and to be deposited on vacuum pumping components.

A schematic block diagram of the second embodiment of plasma doping module 110 is shown in FIG. 7. The embodiment of FIG. 7 differs from the embodiment of FIGS. 5 and 6 with respect to grounding and the electrical connections to pulse source 132 and hollow electrode pulse source 190. In particular, anode 170 is connected to a reference potential, such as ground, and the cathode (platen 76) is pulsed negative for implantation of positive ions. In this respect the embodiment of FIG. 7 falls outside the scope of the claims. Hollow electrode 170 is connected by switch 184 to platen 76 or to hollow electrode pulse source 190, depending on the required implant energy. In the embodiment of FIG. 7, platen halo 162 is an electrically insulating material to permit electrical isolation between platen 76 and plasma doping chamber 120.

The embodiment of FIG. 7 also differs from the embodiment of FIGS. 5 and 6 with respect to the vacuum pumping arrangement. In particular, plasma doping chamber 120 is provided with a controlled conductance aperture 194, and vacuum pump 126 (FIGS. 5 and 6) is eliminated. The controlled conductance aperture 194 provides a controlled gas flow between the interior volume of plasma doping chamber 120 and process chamber 74. Thus, plasma doping chamber 120 is vacuum pumped by a controlled gas flow through aperture 194 to vacuum pump 142 when platen 76 is sealed into plasma doping chamber 120. The controlled conductance aperture 194 may include one or more openings having known gas flow characteristics. In one embodiment, the openings of aperture 194 avoid a direct line of sight between the interior volume of plasma doping chamber 120 and process chamber 74, to permit gas flow while inhibiting passage of the plasma. For example, aperture 194 may be implemented as a gas conduit having a bend. In other embodiments, aperture 194 may be fixed, may be opened or closed, or may have an adjustable gas conductance. It will be understood that the vacuum pumping arrangement of FIG. 7 may be used in the embodiment of FIGS. 5 and 6. Further, the vacuum pumping arrangement of FIGS. 5 and 6 may be used in the embodiment of FIG. 7.

The plasma doping systems shown in FIGS. 5-7 and described above may be utilized in the integrated processing system shown in FIGS. 2-4 and described above. In addition, the embodiments of FIGS. 5-7 may be utilized separately or in any processing system having an outer vacuum vessel to provide vacuum pumping of the plasma doping chamber as described above. The outer vacuum vessel may or may not include another processing module.

Other plasma doping architectures may be utilized within the scope of the invention as claimed. For example, the plasma may be pulsed or continuous. The plasma may be generated by a DC voltage, an RF voltage or a microwave voltage, each of which may be pulsed or continuous. Different process gas pressures may be utilized.

It should be understood that various changes and modifications of the embodiments shown in the drawings described in the specification may be made within the scope of the present invention. Accordingly, it is intended that all matter contained in the above description and shown in the accompanying drawings be interpreted in an illustrative and not in a limiting sense. The invention is limited only as defined in the following claims.

## Claims

1. Plasma doping apparatus comprising:
a housing defining a plasma doping chamber (120);
a platen (76) for supporting a workpiece in said plasma doping chamber, said platen coupled to a reference potential;
an anode (170) spaced from said platen in said plasma doping chamber;
a process gas source (124) coupled to said plasma doping chamber, wherein a plasma containing ions of the process gas is produced in said plasma doping chamber between said anode and said platen, said plasma having a plasma sheath in the vicinity of the workpiece;
a vacuum vessel (75) enclosing said plasma doping chamber and defining an outer chamber (74);
a primary vacuum pump (142) connected to said vacuum vessel;
a pulse source (132) for applying pulses to said anode for accelerating said ions across the plasma sheath toward said platen for implantation into the workpiece; and
a controller (150) arranged for establishing a controlled plasma doping environment in the plasma doping chamber in a processing mode and for establishing a gas connection between the plasma doping chamber and the outer chamber in a non-processing mode.

2. Plasma doping apparatus as defined in claim 1, further comprising a secondary vacuum pump (126) connected to said plasma doping chamber for pumping said plasma doping chamber in the processing mode.

3. Plasma doping apparatus as defined in claim 1, further comprising a controlled conductance aperture between said plasma doping chamber and said outer chamber, wherein said plasma doping chamber is pumped through said controlled conductance aperture in the processing mode.

4. Plasma doping apparatus as defined in claim 1, further comprising a hollow electrode surrounding a space between said platen and said anode, and electrically connected to said anode.

5. Plasma doping apparatus as defined in claim 1, further comprising a hollow electrode (172) surrounding a space between said platen and said anode, and a hollow electrode pulse source electrically connected to said hollow electrode, wherein said plasma is produced by the pulses applied to said anode and the pulses applied to said hollow electrode.

6. A plasma doping method comprising the steps of:
providing a plasma doping chamber (120) containing a platen (76) coupled to a reference potential and an anode (170) spaced from the platen;
supporting a workpiece on the platen;
supplying a process gas to the plasma doping chamber, wherein a plasma containing ions of the process gas is produced in said plasma doping chamber between said anode and said platen, said plasma having a plasma sheath in the vicinity of the workpiece;
enclosing the plasma doping chamber within a vacuum vessel (75) that defines an outer chamber (74);
vacuum pumping the vacuum vessel with a primary vacuum pump (142);
applying pulses to the anode for accelerating the ions across the plasma sheath toward the platen for implantation into the workpiece; and
controlling the apparatus thereby establishing a controlled plasma doping environment in the plasma doping chamber in a processing mode and establishing a gas connection between the plasma doping chamber and the outer chamber in a non-processing mode.

7. A plasma doping method as defined in claim 6, further comprising the step of controllably moving said platen between a processing position sealed into said plasma doping chamber in the processing mode and a retracted position removed from said plasma doping chamber in the non-processing mode.

8. A plasma doping method as defined in claim 6, further comprising the step of vacuum pumping said plasma doping chamber in the processing mode with a secondary vacuum pump (126) connected to said plasma doping chamber.

9. A plasma doping method as defined in claim 6, further comprising the step of vacuum pumping said plasma doping chamber in the processing mode with said primary vacuum pump, wherein said primary vacuum pump communicates with said plasma doping chamber through a controlled conductance aperture between said plasma doping chamber and said outer chamber.

10. A plasma doping method as defined in claim 6, further comprising the steps of providing a hollow electrode (172) surrounding a space between said platen and said anode, and electrically connecting said hollow electrode to said anode.

11. A plasma doping method as defined in claim 6, further comprising the steps of providing a hollow electrode (172) surrounding a space between said platen and said anode, and electrically connecting said hollow electrode to a hollow electrode pulse source for applying pulses to said hollow electrode, wherein said plasma is produced by the pulses applied to said anode and the pulses applied to said hollow electrode.

## Patentansprüche

1. Plasmadotiervorrichtung, die folgendes einschließt:
ein Gehäuse, das eine Plasmadotierkammer (120) definiert;
eine Platte (76) in der Plasmadotierkammer zum Tragen eines Werkstücks, wobei die Platte an ein Bezugspotential angeschlossen ist;
eine Anode (170), die mit Abstand zu der Platte in der Plasmadotierkammer angeordnet ist;
eine Prozessgasquelle (124), die mit der Plasmadotierkammer verbunden ist, wobei ein Plasma, das Ionen vom Prozessgas enthält, in der Plasmadotierkammer zwischen der Anode und der Platte erzeugt wird, wobei das Plasma in der Nähe des Werkstücks eine Plasmahülle aufweist;
ein Unterdruckgefäß (75), das die Plasmadotierkammer einschließt und eine äußere Kammer (74) definiert;
eine Hauptvakuumpumpe (142), die mit dem Unterdruckgefäß verbunden ist;
eine Pulsquelle (132), zum Anlegen von Pulsen an die Anode, um die Ionen über die Plasmahülle hinweg in Richtung auf die Platte zu beschleunigen, um sie in das Werkstück zu implantieren; und
eine Steuereinrichtung (150), die so ausgelegt ist, dass sie in einem Aufbereitungsmodus eine gesteuerte Plasmadotierungsumgebung in der Plasmadotierkammer einrichtet und in einem Nicht-Aufbereitungsmodus eine Gasverbindung zwischen der Plasmadotierkammer und der Außenkammer einrichtet.

2. Plasmadotiervorrichtung nach Anspruch 1, die ferner eine Hilfsvakuumpumpe (126) aufweist, die mit der Plasmadotierkammer verbunden ist, um die Plasmadotierkammer im Aufbereitungsmodus zu evakuieren.

3. Plasmadotiervorrichtung nach Anspruch 1, die ferner eine gesteuerte Leitungsöffnung zwischen der Plasmadotierkammer und der Außenkammer aufweist, wobei die Plasmadotierkammer im Aufbereitungsmodus durch die Leitungsöffnung evakuiert wird.

4. Plasmadotiervorrichtung nach Anspruch 1, die ferner eine Hohlelektrode aufweist, die einen Raum zwischen der Platte und der Anode umgibt und die elektrisch mit der Anode verbunden ist.

5. Plasmadotiervorrichtung nach Anspruch 1, die ferner eine Hohlelektrode (172) aufweist, die einen Raum zwischen der Platte und der Anode umgibt, sowie eine Hohlelektroden-Pulsquelle, die elektrisch mit der Hohlelelctrode verbunden ist, wobei das Plasma von den Pulsen, die an die Anode angelegt werden, und den Pulsen, die an die Hohlelektrode angelegt werden, erzeugt wird.

6. Plasmadotierverfahren, das folgendes umfasst:
Bereitstellen einer Plasmadotierkammer (120), die eine Platte (76) enthält, die an ein Bezugspotential angeschlossen ist, sowie eine Anode (170), die mit Abstand von der Platte angeordnet ist;
Anbringen eines Werkstücks auf der Platte;
Liefern von Prozessgas zur Plasmadotierkammer, wobei en Plasma, das Ionen vom Prozessgas enthält, in der Plasmadotierkammer zwischen der Anode und der Platte erzeugt wird, wobei das Plasma in der Nähe des Werkstücks eine Plasmahülle aufweist;
Umschließen der Plasmadotierkammer mit einem Vakuumgefäß (75), das eine Außenkammer (74) definiert;
Evakuieren des Vakuumgefäßes mit einer Hauptvakuumpumpe (142);
Anlegen von Pulsen an die Anode, um die Ionen über die Plasmahülle hinweg in Richtung auf die Platte zu beschleunigen, um sie in das Werkstück zu implantieren; und
Steuern der Vorrichtung, um dadurch in einem Aufbereitungsmodus eine gesteuerte Plasmadotierungsumgebung in der Plasmadotierkammer einzurichten, und in einem Nicht-Aufbereitungsmodus eine Gasverbindung zwischen der Plasmadotierkammer und der Außenkammer einzurichten.

7. Plasmadotierverfahren nach Anspruch 6, das ferner den Schritt der steuerbaren Bewegung der Platte zwischen einer Aufbereitungsstellung, in der sie im Aufbereitungsmodus in der Plasmadotierkammer abgeschlossen angeordnet ist, und einer Rückzugsstellung, in die sie im Nicht-Aufbereitungsmodus von der Plasmadotierkammer wegbewegt wird, einschließt.

8. Plasmadotierverfahren nach Anspruch 6, das im Aufbereitungsmodus ferner den Schritt des Evakuierens der Plasmadotierkammer mit einer Hilfsvakuumpumpe (126), die mit der Plasmadotierkammer verbunden ist, einschließt.

9. Plasmadotierverfahren nach Anspruch 6, das im Aufbereitungsmodus ferner den Schritt des Evakuierens der Plasmadotierkammer mit der Hauptvakuumpumpe einschließt, wobei die Hauptvakuumpumpe über eine gesteuerte Leitungsöffnung zwischen der Plasmadotierkammer und der Außenkammer mit der Plasmadotierkammer kommuniziert.

10. Plasmadotierverfahren nach Anspruch 6, das ferner die Schritte des Bereitstellens einer Hohlelektrode (172), die den Raum zwischen der Platte und der Anode umgibt, und des elektrischen Anschließens der Hohlelektrode an die Anode einschließt.

11. Plasmadotierverfahren nach Anspruch 6, das ferner die Schritte des Bereitstellens einer Hohlelektrode (172), die einen Raum zwischen der Platte und der Anode umgibt, und des elektrischen Anschließens der Hohlelektrode an einer Hohlelektroden-Pulsquelle zum Anlegen von Pulsen an die Hohlelektrode einschließt, wobei das Plasma durch die Pulse, die an die Anode angelegt werden, und die Pulse, die an die Hohlelektrode angelegt werden, erzeugt wird.

## Revendications

1. Appareil de dopage au plasma comprenant :
un logement définissant une chambre de dopage au plasma (120) ;
un plateau (76) destiné à supporter une pièce à travailler dans ladite chambre de dopage au plasma, ledit plateau étant couplé à un potentiel de référence ;
une anode (170) espacée dudit plateau dans ladite chambre de dopage au plasma ;
une source de gaz de traitement (124) couplée à ladite chambre de dopage au plasma, dans laquelle un plasma contenant des ions du gaz de traitement est produit dans ladite chambre de dopage au plasma entre ladite anode et ledit plateau, ledit plasma ayant une gaine de plasma au voisinage de la pièce à travailler ;
une cuve à vide (75) enfermant ladite chambre de dopage au plasma et définissant une chambre externe (74) ;
une pompe à vide primaire (142) reliée à ladite cuve à vide ;
une source d'impulsions (132) destinée à appliquer des impulsions à ladite anode pour accélérer lesdits ions à travers la gaine de plasma vers ledit plateau pour implantation dans la pièce à travailler ; et
une unité de commande (150) agencée pour établir un environnement de dopage au plasma commandé dans la chambre de dopage au plasma dans un mode de traitement et pour établir un raccord de gaz entre la chambre de dopage au plasma et la chambre externe dans un mode de non traitement.

2. Appareil de dopage au plasma selon la revendication 1, comprenant en outre une pompe à vide secondaire (126) reliée à ladite chambre de dopage au plasma pour pomper ladite chambre de dopage au plasma dans le mode de traitement.

3. Appareil de dopage au plasma selon la revendication 1, comprenant en outre une ouverture à conductance commandée entre ladite chambre de dopage au plasma et ladite chambre externe, dans lequel ladite chambre de dopage au plasma est pompée à travers ladite ouverture à conductance commandée dans le mode de traitement.

4. Appareil de dopage au plasma selon la revendication 1, comprenant en outre une électrode creuse entourant un espace entre ledit plateau et ladite anode, et électriquement connectée à ladite anode.

5. Appareil de dopage au plasma selon la revendication 1, comprenant en outre une électrode creuse (172) entourant un espace entre ledit plateau et ladite anode, et une source d'impulsions d'électrode creuse électriquement connectée à ladite électrode creuse, dans lequel ledit plasma est produit par les impulsions appliquées à ladite anode et les impulsions appliquées à ladite électrode creuse.

6. Procédé de dopage au plasma comprenant les étapes consistant à :
fournir une chambre de dopage au plasma (120) contenant un plateau (76) couplé à un potentiel de référence et une anode (170) espacée du plateau ;
supporter une pièce à travailler sur le plateau ;
fournir un gaz de traitement à la chambre de dopage au plasma, dans lequel un plasma contenant des ions du gaz de traitement est produit dans ladite chambre de dopage au plasma entre ladite anode et ledit plateau, ledit plasma ayant une gaine de plasma au voisinage de la pièce à travailler ;
enfermer la chambre de dopage au plasma au sein d'une cuve à vide (75) qui définit une chambre externe (74) ;
pomper sous vide la cuve à vide avec une pompe à vide primaire (142) ;
appliquer des impulsions à l'anode pour accélérer les ions à travers la gaine de plasma vers le plateau pour implantation dans la pièce à travailler ; et
commander l'appareil, établissant ainsi un environnement de dopage au plasma commandé dans la chambre de dopage au plasma dans un mode de traitement et établissant un raccord de gaz entre la chambre de dopage au plasma et la chambre externe dans un mode de non traitement.

7. Procédé de dopage au plasma selon la revendication 6, comprenant en outre l'étape consistant à déplacer de manière commandable ledit plateau entre une position de traitement scellée dans ladite chambre de dopage au plasma dans le mode de traitement et une position rétractée retirée de ladite chambre de dopage au plasma dans le mode de non traitement.

8. Procédé de dopage au plasma selon la revendication 6, comprenant en outre l'étape consistant à pomper sous vide ladite chambre de dopage au plasma dans le mode de traitement avec une pompe à vide secondaire (126) reliée à ladite chambre de dopage au plasma.

9. Procédé de dopage au plasma selon la revendication 6, comprenant en outre l'étape consistant à pomper sous vide ladite chambre de dopage au plasma dans le mode de traitement avec ladite pompe à vide primaire, dans lequel ladite pompe à vide primaire communique avec ladite chambre de dopage au plasma à travers une ouverture à conductance commandée entre ladite chambre de dopage au plasma et ladite chambre externe.

10. Procédé de dopage au plasma selon la revendication 6, comprenant en outre les étapes consistant à fournir une électrode creuse (172) entourant un espace entre ledit plateau et ladite anode, et connecter électriquement ladite électrode creuse à ladite anode.

11. Procédé de dopage au plasma selon la revendication 6, comprenant en outre les étapes consistant à fournir une électrode creuse (172) entourant un espace entre ledit plateau et ladite anode, et connecter électriquement ladite électrode creuse à une source d'impulsions d'électrode creuse destinée à appliquer des impulsions à ladite électrode creuse, dans lequel ledit plasma est produit par les impulsions appliquées à ladite anode et les impulsions appliquées à ladite électrode creuse.
